# EUROPEAN PATENT APPLICATION

(11) **EP 4 539 267 A1**
(43) Date of publication of application: **16.04.2025**
(21) Application number: 23819903.8
(22) Date of filing: 09.06.2023
(51) Int. Cl.: H01S 5/02, H01S 5/022, H01S 5/0234, H01S 5/22

(54) **METHOD AND APPARATUS FOR PRODUCING SEMICONDUCTOR LASER DEVICE**

(30) Priority: 09.06.2022 JP 2022093961
(71) Applicant: Kyocera Corporation, Kyoto-shi, Kyoto 612-8501 (JP)
(72) Inventor: KAWAGUCHI, Yoshinobu, Kyoto-shi, Kyoto 612-8501 (JP); MURAKAWA, Kentaro, Kyoto-shi, Kyoto 612-8501 (JP); KAMIKAWA, Takeshi, Kyoto-shi, Kyoto 612-8501 (JP); USAGAWA, Motohisa, Kyoto-shi, Kyoto 612-8501 (JP); KOMODA, Akiko, Kyoto-shi, Kyoto 612-8501 (JP); TONOMURA, Mizuki, Kyoto-shi, Kyoto 612-8501 (JP); YOKOYAMA, Takeshi, Kyoto-shi, Kyoto 612-8501 (JP)
(74) Representative: Viering, Jentschura & Partner mbB Patent- und Rechtsanwälte
(86) International application number: PCT/JP2023/021468
(87) International publication number: WO 2023/238923

(57) **Abstract**

A method includes preparing a semiconductor substrate including a first substrate and a plurality of semiconductor parts having a stripe shape and obtained by crystal growth on the first substrate, dividing each of a plurality of structures including a respective one of the plurality of semiconductor parts on the first substrate in a manner that an end surface parallel to a lateral direction is exposed at each structure and thus obtaining an individual body group, transferring a plurality of individual bodies included in the individual body group to a second substrate, and dividing the second substrate and thus obtaining each of a plurality of element substrates including a respective one or more of the plurality of individual bodies.

## Description

### TECHNICAL FIELD

The present disclosure relates to a manufacturing method for a semiconductor laser device and the like.

### BACKGROUND OF INVENTION

Patent Document 1 discloses a method in which an element structure wafer having a laser element structure formed on a growth substrate is bonded to a support substrate, and the bonded wafer obtained in this manner is divided to obtain a laser element with a support substrate including a light emitting end surface and a light reflecting end surface.

### CITATION LIST

### PATENT LITERATURE

Patent Document 1: JP 2019-46868 A

### SUMMARY

In an embodiment of the present disclosure, a manufacturing method for a semiconductor laser device includes preparing a semiconductor substrate including a first substrate and a plurality of semiconductor parts having a stripe shape and obtained by crystal growth on the first substrate, dividing each of a plurality of structures including a respective one of the plurality of semiconductor parts on the first substrate in a manner that an end surface parallel to a lateral direction is exposed at each of the plurality of structures and thus obtaining an individual body group, transferring a plurality of individual bodies included in the individual body group to a second substrate, and dividing the second substrate and thus obtaining each of a plurality of element substrates including a respective one or more of the plurality of individual bodies.

### BRIEF DESCRIPTION OF THE DRAWINGS

FIG. 1 is a perspective view illustrating a manufacturing method for a semiconductor laser device according to an embodiment.
FIG. 2 is a flowchart illustrating the manufacturing method for the semiconductor laser device according to the embodiment.
FIG. 3 is a block diagram illustrating a manufacturing apparatus for a semiconductor device according to an embodiment.
FIG. 4 is a flowchart illustrating a manufacturing method for a semiconductor laser device according to an example.
FIG. 5 is a plan view illustrating the manufacturing method for the semiconductor laser device according to the example.
FIG. 6 is a cross-sectional view illustrating the manufacturing method for the semiconductor laser device according to the example.
FIG. 7 is a perspective view illustrating an arrangement of individual bodies on a second substrate according to the example.
FIG. 8A is a cross-sectional view illustrating a configuration example of an individual body (laser body) according to the example and being perpendicular to a resonator length direction.
FIG. 8B is a cross-sectional view illustrating the configuration example of the individual body (laser body) according to the example and being parallel to the resonator length direction.
FIG. 9 is a perspective view illustrating a configuration of an element substrate and laser elements according to the example.
FIG. 10 is a plan view illustrating a manufacturing method for a semiconductor laser device according to an example.
FIG. 11 is a plan view illustrating the manufacturing method for the semiconductor laser device according to the example.
FIG. 12 is a plan view illustrating the manufacturing method for the semiconductor laser device according to the example.
FIG. 13 is a cross-sectional view illustrating a configuration example of a base substrate included in a first substrate.
FIG. 14 is a cross-sectional view illustrating a manufacturing method for manufacturing a semiconductor substrate according to an example.
FIG. 15 is a plan view illustrating a manufacturing method for a semiconductor laser device according to an example.
FIG. 16 is a cross-sectional view illustrating a manufacturing method for a semiconductor laser device according to an example.
FIG. 17 is a cross-sectional view illustrating a manufacturing method for a semiconductor laser device according to an example.
FIG. 18 is a cross-sectional view illustrating a manufacturing method for a semiconductor laser device according to an example.
FIG. 19 is a cross-sectional view illustrating a manufacturing method for a semiconductor laser device according to an example.
FIG. 20 is a perspective view illustrating a manufacturing method for a semiconductor laser device according to an example.
FIG. 21 is a cross-sectional view illustrating the manufacturing method for the semiconductor laser device according to the example.
FIG. 22 is a cross-sectional view illustrating a manufacturing method for a semiconductor laser device according to an example.
FIG. 23 is a perspective view illustrating the manufacturing method for the semiconductor laser device according to the example.
FIG. 24 is a cross-sectional view illustrating a manufacturing method for a semiconductor laser device according to an example.

### DESCRIPTION OF EMBODIMENTS

### Manufacturing Method for Semiconductor Laser Device

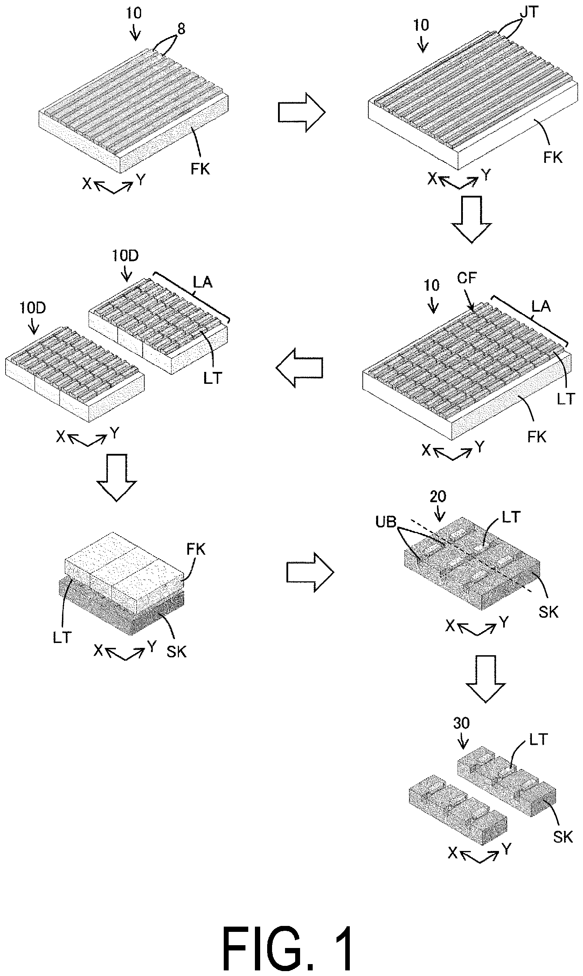

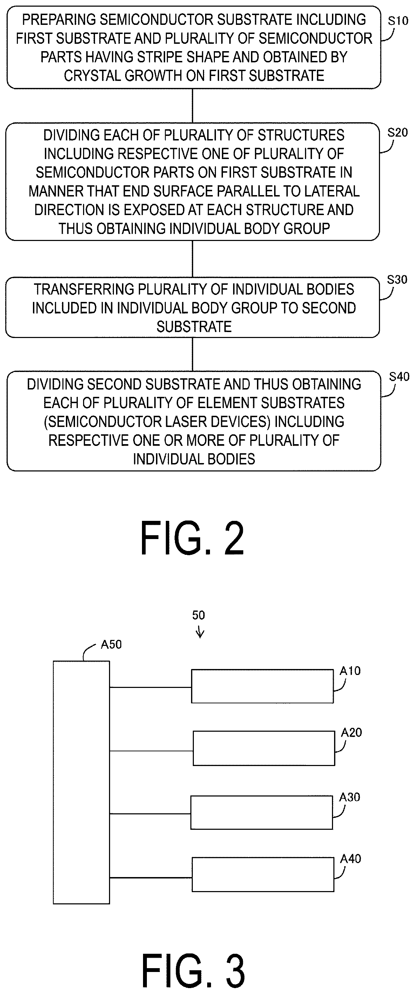

FIG. 1 is a perspective view illustrating a manufacturing method for a semiconductor laser device according to an embodiment. FIG. 2 is a flowchart illustrating the manufacturing method for the semiconductor laser device according to the embodiment.

The manufacturing method for the semiconductor laser device illustrated in FIG. 1 and FIG. 2 includes a step (S10) of preparing a semiconductor substrate 10 including a first substrate FK and a plurality of semiconductor parts 8 having a stripe shape and obtained by crystal growth on the first substrate FK, a step (S20) of dividing each of a plurality of structures JT including a respective one of the plurality of semiconductor parts 8 on the first substrate FK in a manner that an end surface CF parallel to a lateral direction (X direction) is formed at each structure JT and thus obtaining an individual body group LA, a step (S30) of transferring a plurality of individual bodies LT included in the individual body group LA to a second substrate SK, and a step (S40) of dividing the second substrate SK and thus obtaining each of a plurality of element substrates 30 including a respective one or more individual bodies LT.

The individual body group LA refers to, for example, four or more individual bodies. After dividing the semiconductor substrate 10 into a plurality of individual substrates 10D, a plurality of individual bodies LT of individual substrate 10D may be transferred to the second substrate SK. As for the semiconductor substrate 10, a direction from the first substrate FK to the semiconductor part 8 is referred to as an "upward direction". Viewing an object with a line of sight parallel to a normal direction of the semiconductor substrate 10 (including viewing an object in a perspective manner) is referred to as "plan view". The semiconductor substrate means a substrate including a semiconductor part, and the first substrate FK, which may be referred to as a template substrate, may include a non-semiconductor (for example, an insulator).

In the manufacturing method for the semiconductor laser device according to the present embodiment, the plurality of individual bodies LT are transferred to the second substrate SK from the individual body group LA obtained by dividing the plurality of structures JT, and then the second substrate SK is divided. Therefore, the manufacturing yield of a semiconductor laser device (for example, the element substrate 30) is increased. Since the plurality of structures JT having the stripe shape along a crystal orientation of the semiconductor parts 8 are divided on the first substrate FK without being transferred, the end surface CF can be formed in a desired shape and at a desired position for each of the plurality of structures JT.

The semiconductor part 8 may be a semiconductor layer containing a nitride semiconductor (for example, a nitride semiconductor crystal). The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The semiconductor part 8 may be of a doped type (for example, n-type including a donor) or a non-doped type.

The division of the plurality of structures JT having the stripe shape may be performed by cleaving or etching (dry or wet etching). The end surface CF formed by dividing the structure JT may include a resonator end surface of the individual body LT (laser body).

In step S30, selective transfer can be performed such that the number of transferred individual bodies per unit area to the second substrate SK is less than the number of individual bodies per unit area in the individual body group LA. For example, an interval between the plurality of individual bodies LT in a Y direction may be equal to or larger than a size (resonator length) of each individual body LT (laser body) in the Y direction. In step S40, the second substrate SK can be divided in a manner not to divide any individual body LT. In this way, contamination of the end surface of the individual body LT (the resonator end surface of the laser body) caused by the division of the second substrate SK can be reduced.

### Manufacturing Apparatus for Semiconductor Laser Device

FIG. 3 is a block diagram illustrating a manufacturing apparatus for a semiconductor device according to the embodiment. As illustrated in FIG. 3, a manufacturing apparatus 50 for a semiconductor device includes an apparatus A10 that performs the step S10, an apparatus A20 that performs the step S20, an apparatus A30 that performs the step S30, an apparatus A40 that performs the step S40, and an apparatus A50 that controls the apparatus A10, the apparatus A20, the apparatus A30, and the apparatus A40.

### Examples

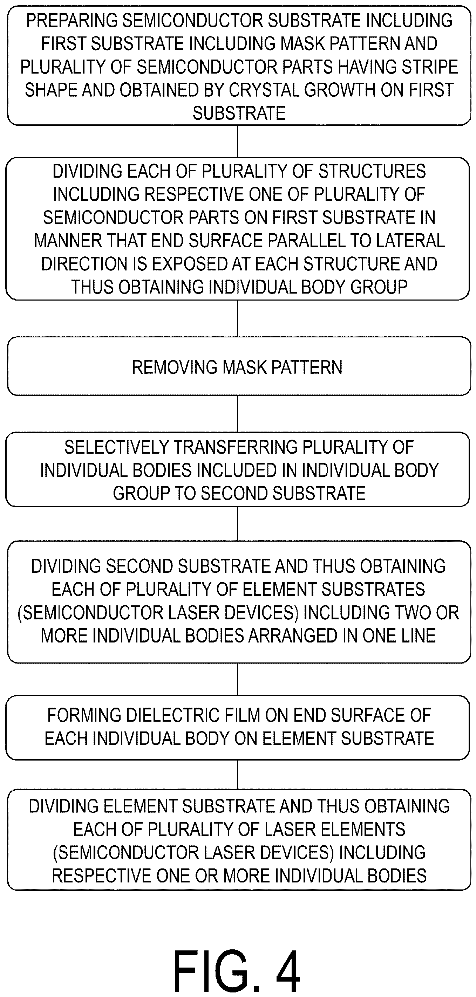

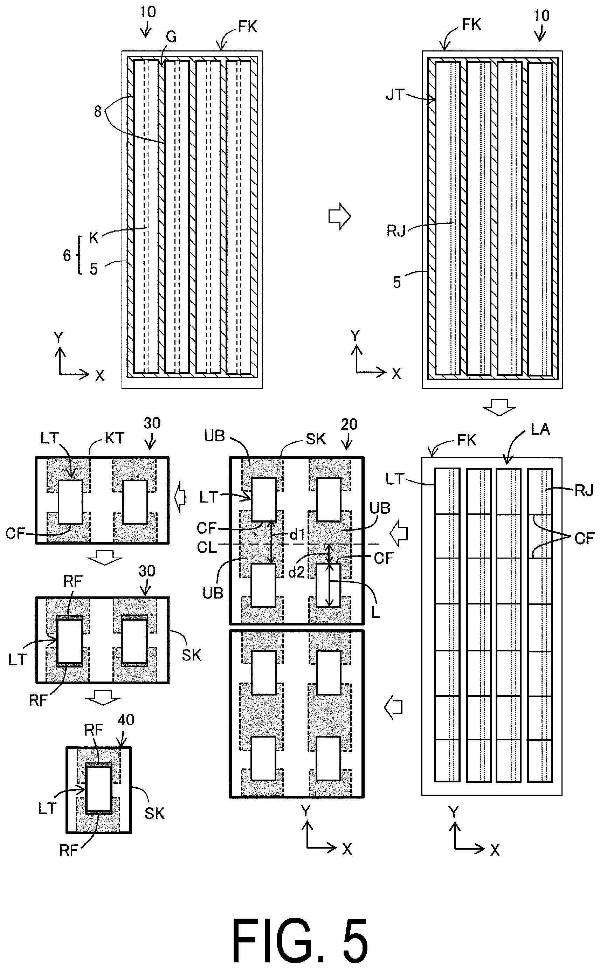

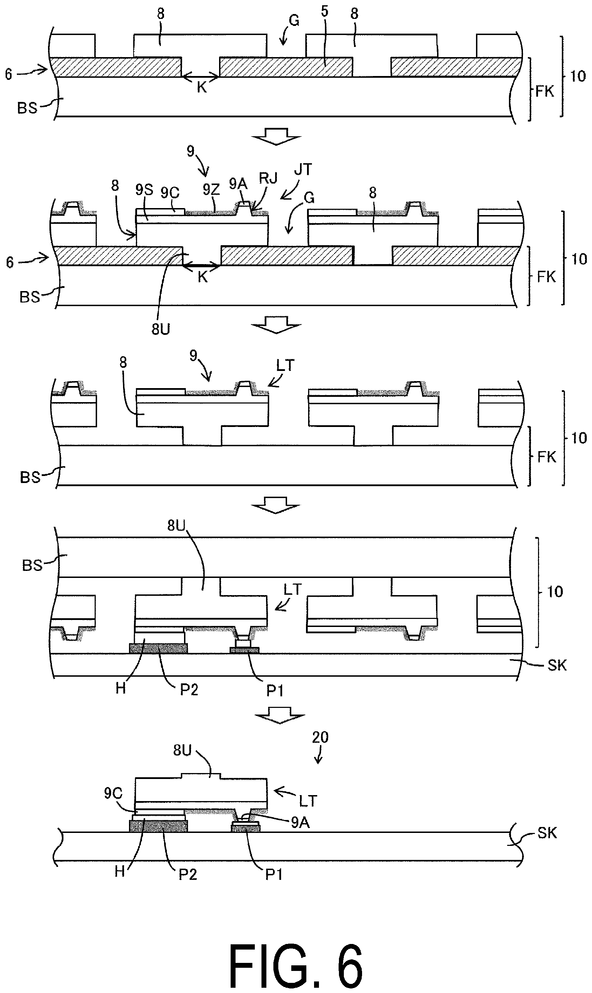

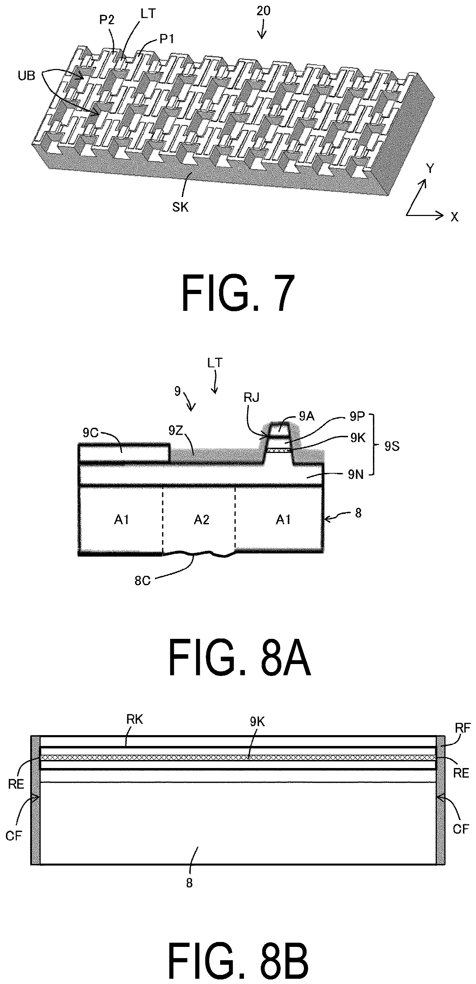

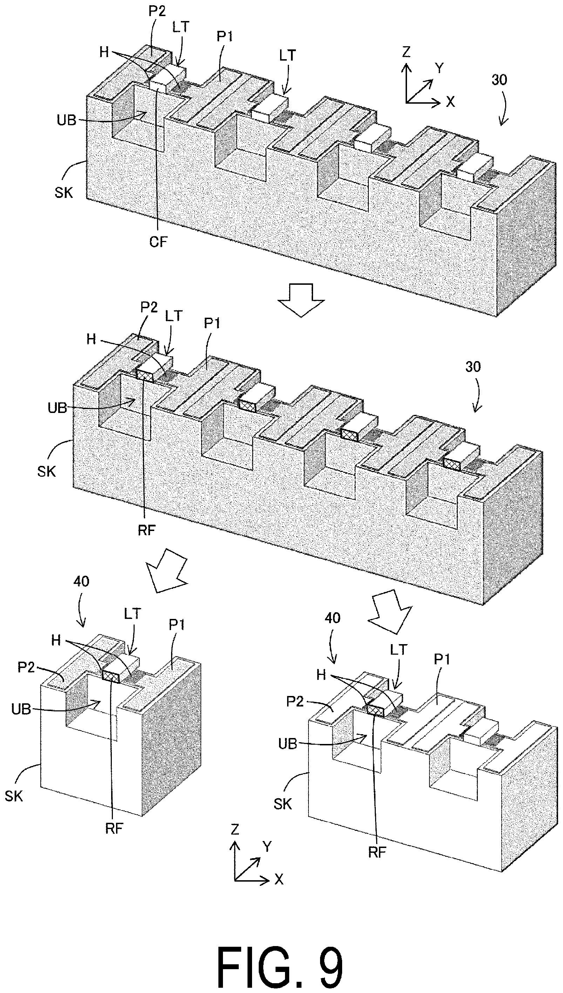

FIG. 4 is a flowchart illustrating a manufacturing method for a semiconductor laser device according to an example. FIG. 5 is a plan view illustrating the manufacturing method for the semiconductor laser device according to the example. FIG. 6 is a cross-sectional view illustrating the manufacturing method for the semiconductor laser device according to the example. FIG. 7 is a perspective view illustrating an arrangement of individual bodies on the second substrate according to the example. FIG. 8A is a cross-sectional view illustrating a configuration example of the individual body (laser body) according to the example, and being perpendicular to a resonator length direction. FIG. 8B is a cross-sectional view illustrating the configuration example of the individual body (laser body) according to the example, and being parallel to the resonator length direction. FIG. 9 is a perspective view illustrating a configuration of an element substrate and laser elements according to the example.

As illustrated in FIG. 4 to FIG. 6, the manufacturing method for the semiconductor laser device includes the steps of preparing the semiconductor substrate 10 including the first substrate FK including a mask part 5 and a mask pattern 6 including an opening K and the plurality of semiconductor parts 8 having a stripe shape and obtained by crystal growth on the first substrate FK, dividing each of the plurality of structures JT including a respective one of the plurality of semiconductor parts 8 on the first substrate FK in the manner that the end surface CF parallel to the lateral direction (X direction) is formed at each structure JT and thus obtaining the individual body group LA, removing the mask pattern 6, transferring the plurality of individual bodies LT included in the individual body group LA to the second substrate SK and thus obtaining the element substrate 20 (semiconductor device) including the plurality of individual bodies LT arranged in a matrix, dividing the second substrate SK and thus obtaining each of the plurality of element substrates 30 (semiconductor devices) including respective two or more individual bodies LT arranged in a line, forming a dielectric film (reflector film) RF on the end surface CF of each individual body LT on the element substrate 30, and dividing the element substrate 30 and thus obtaining each of the plurality of laser elements 40 (semiconductor devices) including a respective one or more individual bodies. Although the mask pattern 6 is removed before the transferring, the transferring may be performed without removing the mask pattern 6.

The first substrate FK (template substrate) may include a base substrate BS, and the mask pattern 6 may be formed on the base substrate BS. The semiconductor part 8 can be formed by an epitaxial lateral overgrowth (ELO) method by setting, a region (seed region of the first substrate FK) where the base substrate BS is exposed from the opening K as a starting point. As the ELO method, vapor phase growth such as metal organic vapor phase growth, hydride vapor phase growth, and molecular beam vapor phase growth can be adopted.

The mask part 5 may be a mask for selective growth (a growth suppression region of the first substrate FK) that laterally causes the semiconductor part 8 to grow. A thickness direction of the semiconductor part 8 may be a c-axis direction (<0001> direction). The opening K may have a longitudinal shape, a width direction thereof may be an a-axis direction (<11-20> direction) of the semiconductor part 8 that is, for example, a nitride semiconductor crystal, and a longitudinal direction thereof may be an m-axis direction. In the mask pattern 6, a plurality of openings K may be arranged in the a-axis direction (X direction) of the semiconductor part 8.

In the ELO method of the present example, the growth is stopped before crystals growing on the mask part 5 in mutually opposite directions (a-axis directions) meet each other, thus the plurality of semiconductor parts 8 having the stripe shape can be formed. The mask part 5 is positioned below a gap G between the adjacent semiconductor parts 8.

As illustrated in FIG. 5 and FIG. 6, the structure JT may include the semiconductor part 8 and an upper layer part 9 positioned on the semiconductor part 8. The upper layer part 9 may include a functional semiconductor layer 9S containing a nitride semiconductor, an insulating film 9Z, and electrodes 9A and 9C. Since the mask part 5 exists under the gap G between the adjacent semiconductor parts 8, the functional semiconductor layer 9S (for example, nitride semiconductor crystal) selectively grows on the semiconductor part 8, and is hardly formed (film-formed) on the mask part 5 facing the gap G and on a side surface of the semiconductor part 8 in the X direction. Therefore, the plurality of structures JT have the stripe shape along the crystal orientation (for example, m-axis orientation) of the semiconductor part 8. The functional semiconductor layer 9S may include a ridge RJ (current constriction part having a protruding shape). In the semiconductor part 8 formed by the ELO method, since a portion on the mask part 5 has fewer defects, which will be described later, the ridge RJ may have a longitudinal shape with the m-axis direction as a longitudinal direction and may overlap the mask part 5 in plan view.

In the example, the plurality of structures JT may be individually divided by cleaving. The semiconductor part 8 may include a nitride semiconductor, and the end surface CF that is a cleaved surface may be parallel to an m-plane of the nitride semiconductor (crystal).

Scribing may be performed to start cleaving each structure JT. The semiconductor part 8 may include a GaN-based semiconductor, and the first substrate FK may include a wafer (for example, a silicon substrate) made of a material having a thermal expansion coefficient less than that of the GaN-based semiconductor. In this case, since internal stress of the semiconductor substrate 10 is released by scribing the semiconductor crystal of each structure JT, the cleaving is allowed to naturally proceed. By performing the scribing on the side surface of the structure JT on a side closer to the ridge RJ, flatness of the resonator end surface (cross section of the ridge RJ) included in the end surface CF can be enhanced.

Each of the first substrate FK and the second substrate SK may include a silicon substrate, or each of the first substrate FK and the second substrate SK may include a silicon carbide substrate. When both the substrates are made of the same material, bonding accuracy can be improved.
Therefore, the step of transferring the plurality of individual bodies LT to the second substrate SK is easily performed by bonding the plurality of individual bodies LT on the first substrate FK to the heated second substrate SK. When the plurality of individual bodies LT are transferred to the second substrate SK, a connection crystal part 8U between the individual body LT and the first substrate FK may be naturally broken. Of course, the connection crystal part 8U may be broken by an external force before the plurality of individual bodies LT are transferred to the second substrate SK.

At the same time when the plurality of individual bodies LT are transferred to the second substrate SK, each individual body LT may be electrically connected to electrode pads (P1 and P2) of the second substrate SK. For example, electrodes of each individual body LT can be connected to the electrode pads (P1 and P2) through solder H (see FIG. 9).

As illustrated in FIG. 5, regarding the transferring of the plurality of individual bodies LT, selective transfer of a thinning-out type can be performed such that the number of transferred individual bodies NS per unit area to the second substrate SK is less than the number of individual bodies NA per unit area in the individual body group LA. NS/NA can be set to 1/4, 1/8, 1/12, or the like. The number of thinning-out in a first direction (X direction) may be greater than the number of thinning-out in a second direction (Y direction). The plurality of individual bodies LT transferred to the second substrate SK may be arranged in a matrix in the X direction and the Y direction, when a direction corresponding to the lateral direction of the plurality of semiconductor parts LT is defined as the first direction (X direction) and a direction corresponding to the longitudinal direction is defined as the second direction (Y direction) at the second substrate SK. An interval d1 between the plurality of individual bodies LT in the Y direction may be equal to or larger than a size (resonator length) of each individual body LT (laser body) in the Y direction. The interval d1 between the plurality of individual bodies LT in the Y direction may be a natural number multiple of the size (resonator length) of each individual body LT in the Y direction. In this case, the second substrate SK can be easily divided. For example, contamination of the end surface of the individual body LT can be reduced without applying a technique such as stealth dicing.

In the present embodiment, for example, even when a resonator length L (the size in the Y direction) of the individual body LT is a short resonator length of 200 µm or less, a distance d2 between the end surface CF and a cut surface CL can be ensured. Therefore, the end surface is hardly contaminated, which is advantageous. The distance d2 between the end surface CF and the (substrate) cut surface CL may be 1/2 or more of the resonator length L. Note that the plurality of element substrates 30 may be obtained by dividing the second substrate SK by stealth dicing. In this way, the contamination of the end surface of the individual body LT can be further reduced.

As illustrated in FIG. 5 and FIG. 7, the second substrate SK may include a plurality of recessed parts UB arranged in the matrix in the first direction (X direction) and the second direction (Y direction). As illustrated in FIG. 5 and FIG. 9, the end surface CF parallel to the lateral direction (X direction) of each of the plurality of individual bodies LT transferred to the second substrate SK may be positioned above a respective one of the plurality of recessed parts UB included in the second substrate KS. In this case, the fact that the formation of the dielectric film on the end surface CF is facilitated and the fact that a laser beam from the individual body LT is less likely to hit the second substrate SK are advantageous.

A cross section (substrate cross section) formed by dividing the second substrate SK may include at least one of the plurality of recessed parts UB. Since the recessed part UB has a small thickness, the substrate can be easily cut.

As illustrated in FIG. 5 and FIG. 9, in each of the plurality of element substrates 30, respective two or more individual bodies LT may be arranged in a line in the first direction (X direction). Arranging the plurality of individual bodies LT in the line facilitates formation of dielectric films RF on the end surfaces CF. Since the end surfaces of the plurality of individual bodies LT are arranged in the line, the element substrate 30 itself can be made to function as a semiconductor laser device. The dielectric film RF may be light reflection containing at least one selected from the group consisting of Al₂O₃, AlN, MgF₂, MgO, Nb₂O₅, SiO₂, Si₃N₄, TiO₂, Ta₂O₅, Y₂O₃, ZnO, and ZrO₂.

As illustrated in FIG. 8A, the laser body LT may include the semiconductor part 8, the functional semiconductor layer 9S (an n-type semiconductor layer 9N, an active layer 9K, and a p-type semiconductor layer 9P) positioned above the semiconductor part 8, an electrode 9A (anode) of the ridge RJ in contact with the p-type semiconductor layer 9P, an electrode 9C (cathode) in contact with the n-type semiconductor layer 9N, and an insulating film 9Z positioned on a side of the ridge RJ.

Each of the n-type semiconductor layer 9N and the p-type semiconductor layer 9P with the active layer 9K interposed therebetween may include an optical guide layer positioned on an inner side (the active layer 9K side) and a cladding layer positioned on an outer side. The active layer 9K may have, for example, a quantum well structure, and holes supplied from the electrode 9A and electrons supplied from the electrode 9C are recombined in the active layer 9K to generate light.
As illustrated in FIG. 8A and FIG. 8B, light generated in the active layer 9K is confined by two cladding layers (of the n-type and p-type) having less indices of refraction, amplified by stimulated emission in a process of reciprocating between end surfaces (resonator end surfaces) RE of a resonator RK, and emitted as a laser beam from one of the resonator end surface RE. The end surface CF of the individual body LT (laser body) may include the resonator end surface RE, and the resonator end surface RE may be covered with the dielectric film RF that is a reflector film.

The semiconductor part 8 may include a first region A1 overlapping the ridge RJ in plan view, and a second region A2 not overlapping the ridge RJ in plan view and having a threading dislocation density higher than that of the first region A1. As illustrated in FIG. 8A, a lower surface (back surface) of the semiconductor part 8 may include a region 8C having a locally great surface roughness (a rough surface region having a greater surface roughness than that of the periphery thereof). A protruding part and/or a recessed part may be generated in the region 8C. For example, a plurality of protruding parts having a random shape and a plurality of recessed parts having a random shape may be formed. The region 8C may be formed on a lower surface of the second region A2. The region 8C may be formed in a manner not to overlap the ridge RJ in plan view. Using the region 8C may enhance heat dissipation. A protective film may be formed by using the same material as that of the dielectric film RF in at least a part of the region 8C.

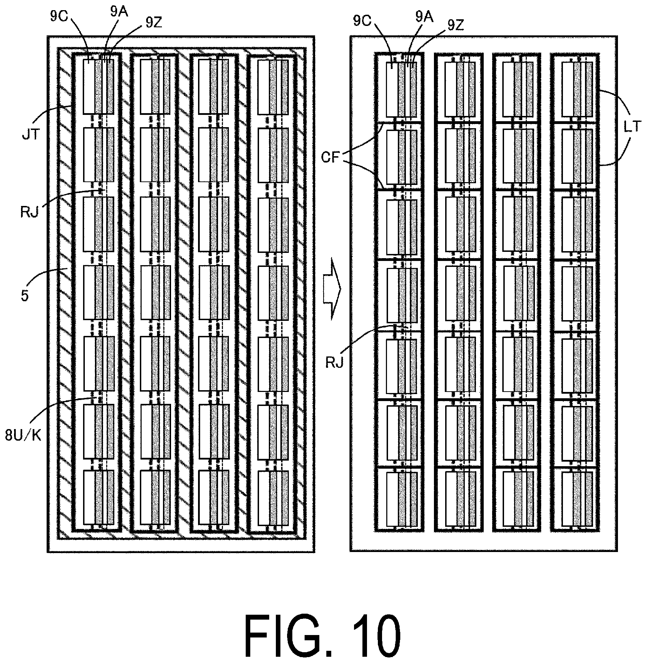

FIG. 10 is a plan view illustrating a manufacturing method for a semiconductor laser device according to an example. Each structure JT includes the ridge RJ, the electrodes 9A and 9C, and the insulating film 9Z. In the semiconductor part 8 formed by the ELO method, since a portion on the mask part 5 has fewer defects, the ridge RJ has a longitudinal shape with the m-axis direction as a longitudinal direction and overlaps the mask part 5 in plan view. The end surface CF may include the ridge RJ that is a part of the functional semiconductor layer 9S, and a cross section (parallel to the a-axis) of the ridge RJ functions as the resonator end surface. That is, the structure JT may be cut in a manner to be orthogonal to an extending direction of the ridge RJ.

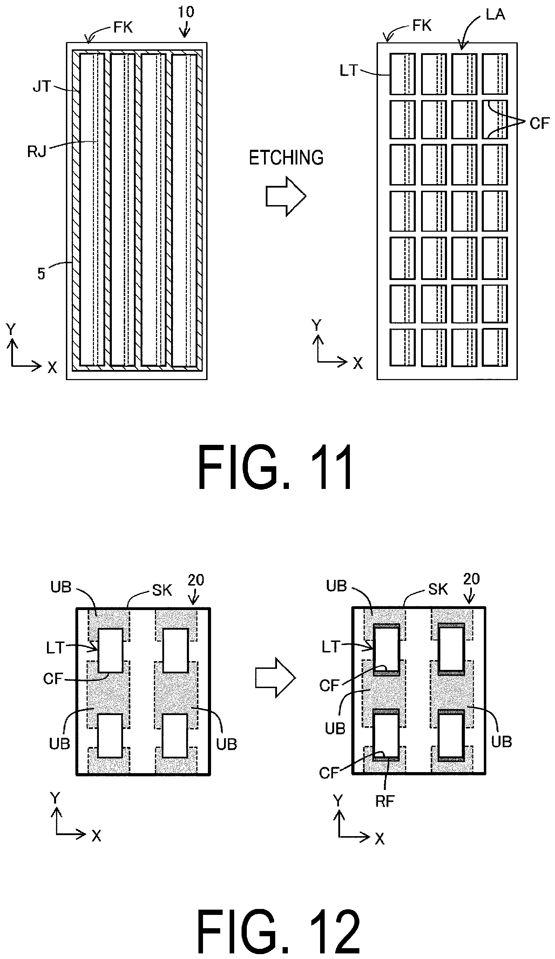

FIG. 11 is a plan view illustrating the manufacturing method for the semiconductor laser device according to the example. The structure JT is divided by cleaving in FIG. 5, but the method is not limited thereto. As illustrated in FIG. 11, the structure JT is divided by etching, and the end surface (including the resonator end surface) of the individual body LT can be used as an etched mirror. In this case, dry etching such as inductively coupled plasma reactive ion etching, wet etching using a solution such as KOH, or the like can be applied. In the example, since each of the plurality of structures JT is formed along the crystal orientation (m-axis orientation, Y direction), a high-quality etched mirror can be obtained.

FIG. 12 is a plan view illustrating the manufacturing method for the semiconductor laser device according to the example. In FIG. 5, in the element substrate in which respective two or more individual bodies LT are arranged in a line, end surface coating (the formation of the dielectric films) of the individual bodies LT is performed, but the manufacturing method is not limited thereto. As illustrated in FIG. 12, the dielectric film RF can also be formed on the end surface CF of each of the plurality of individual bodies LT arranged in the matrix on the second substrate SK. Performing the selective transfer to the second substrate SK causes an interval between the end surfaces to become wider than that before the transfer, thus the dielectric film RF can be formed even when the plurality of individual bodies LT are arranged in the matrix.

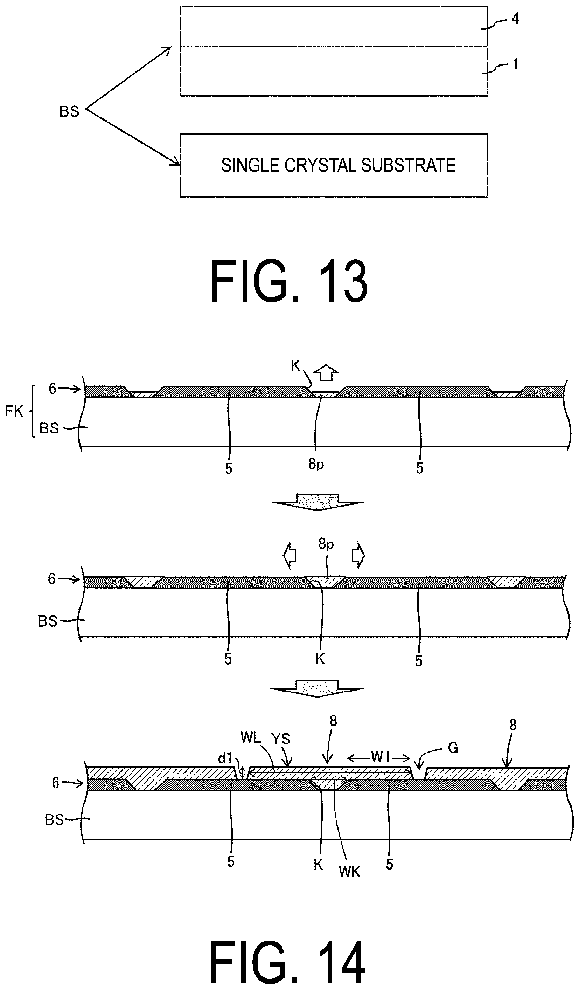

FIG. 13 is a cross-sectional view illustrating a configuration example of a base substrate included in the first substrate. The base substrate BS may include a main substrate 1 that is a heterogeneous substrate having a lattice constant different from that of the semiconductor part 8. The semiconductor part 8 may include a GaN-based semiconductor, and the main substrate 1 that is the heterogeneous substrate may be a silicon substrate. In addition to the silicon substrate, examples of the heterogeneous substrate include a sapphire (Al₂O₃) substrate, and a silicon carbide (SiC) substrate. A plane orientation of the main substrate 1 is, for example, the (111) plane of the silicon substrate, the (0001) plane of the sapphire substrate, or the 6H-SiC (0001) plane of the SiC substrate. These are merely examples, and any substrate and any plane orientation may be used as long as the semiconductor part 8 can be grown by the ELO method.

The base substrate BS may include the main substrate 1 and the underlying part 4 on the main substrate 1, and the semiconductor part 8 may be grown from an upper surface (seed region) of the underlying part 4 exposed at the opening K. The underlying part 4 may contain, for example, a nitride semiconductor. The underlying part 4 may include a buffer part and/or a seed part. That is, the underlying part 4 may be constituted by the seed part, or the underlying part 4 may be constituted by the buffer part (main substrate side) and the seed part (semiconductor part side). As the buffer part, a GaN-based semiconductor, AlN, SiC, or the like may be used. As the seed part, a nitride semiconductor (for example, GaN-based semiconductor) may be used. The base substrate BS may be constituted by a freestanding single crystal substrate (for example, a wafer cut out from a bulk crystal) of GaN, SiC, or the like, and the mask pattern 6 may be disposed on the single crystal substrate.

FIG. 14 is a cross-sectional view illustrating a manufacturing method for a semiconductor substrate according to an example. In FIG. 14, the mask pattern 6 including the plurality of mask parts 5 having a stripe shape is provided on the base substrate BS. The mask part 5 is constituted by a laminated insulating film (SiOx/SiNx) having a width of 52 µm, for example, and extends in the m-axis direction of the semiconductor part 8 as a longitudinal direction. A stripe pitch of the mask parts 5 is 55 µm. The semiconductor part 8 (nitride semiconductor part) is grown on the mask pattern 6 by metal organic chemical vapor deposition (MOCVD) using, for example, trimethyl gallium (TMG) and ammonia (NH₃) (the ELO method).

An initial growth part 8p serves as a starting point of the lateral growth of the semiconductor part 8. The initial growth part 8p can be formed to have a thickness of, for example, 30 nm to 1000 nm, 50 nm to 400 nm, or 70 nm to 350 nm. By making the initial growth part 8p, being in a slightly protruding state from the mask part 5, laterally grow, growth of the semiconductor part 8 in the c-axis direction (thickness direction) can be suppressed, the semiconductor part 8 can be laterally grown at a high speed and with high crystallinity, and consumption of raw materials is also reduced. As a result, the semiconductor part 8 (a crystal body of a nitride semiconductor such as GaN) having fewer defects can be thinly and widely formed at a low cost.

The semiconductor parts 8 laterally grown in opposite directions from the two adjacent openings K are not in contact with (do not meet) each other on the mask part 5 but have the gap (interval) G, thereby making it possible to reduce an internal stress in the semiconductor parts 8. This can reduce the number of cracks and defects (dislocations) that may be produced in the semiconductor parts 8. This effect is particularly exhibited when the main substrate 1 is a heterogeneous substrate. A width of the gap G may be set to, for example, 10 µm or less, 5 µm or less, 3 µm or less, or 2 µm or less.

A portion positioned above the initial growth part 8p, of the first semiconductor part 8, serves as a dislocation inheritance part in which a greater number of threading dislocations occur, and a portion positioned above the mask part 5 (wing part) serves as a low-defect part YS (a first region A1 in FIG. 8) having a threading dislocation density equal to or lower than 1/10 of a threading dislocation density of the dislocation inheritance part. The threading dislocation is a dislocation (defect) extending in the c-axis direction (<0001> direction) in the semiconductor part 8. The threading dislocation density of the low-defect part YS may be set to, for example, 5 × 10⁶ [pieces/cm²] or less. As described above, when the active layer 9K including a light-emitting part is formed above the semiconductor part 8, the light-emitting part can be disposed above the low-defect part YS (in a manner to overlap the low-defect part YS in plan view).

Regarding the low-defect part YS, a ratio (W1/d1) of a size W1 in the a-axis direction to a thickness d1 may be set to 2.0 or more, for example. Using the technique of the example makes it possible to set W1/d1 to 1.5 or more, 2.0 or more, 4.0 or more, 5.0 or more, 7.0 or more, or 10.0 or more. Setting W1/d1 to 1.5 or more facilitates the step of dividing the semiconductor part 8 (for example, a step of dividing in which the cross section is made as an m-plane) in a subsequent step. The internal stress of the semiconductor part 8 is reduced and warping of the semiconductor substrate 10 is reduced.

An aspect ratio of the semiconductor part 8 (the ratio of the size in the X direction to the thickness = WL/d1) may be set to 3.5 or more, 5.0 or more, 6.0 or more, 8.0 or more, 10 or more, 15 or more, 20 or more, 30 or more, or 50 or more. Using the technique of the example makes it possible to set a ratio of the size WL of the semiconductor part 8 in the X direction to the width WK of the opening K (WL/WK) to 3.5 or more, 5.0 or more, 6.0 or more, 8.0 or more, 10 or more, 15 or more, 20 or more, 30 or more, or 50 or more, and makes it possible to raise a rate of the low-defect part. The semiconductor part 8 (including the initial growth part 8p) illustrated in FIG. 14 may be a nitride semiconductor crystal (for example, a GaN crystal, an AlGaN crystal, an InGaN crystal, or an InAlGaN crystal).

### Other Examples

In the example described above, the semiconductor laser device including the individual body LT having the single-sided two-electrode structure in which the electrodes 9A and 9C are provided on the same side with respect to the semiconductor part 8 has been described. However, in another example, the individual body LT may have a structure (double-sided electrode structure) in which the electrode 9C is provided on the side opposite to a side on which the electrode 9A is provided. For example, after the individual body LT is transferred to the second substrate SK, the electrode 9C electrically connected to the semiconductor part 8 may be formed on the surface of the individual body LT on the side opposite to the side where the electrode 9A is provided.

The dislocation inheritance part may be removed by etching or the like. In this case, the structure JT may be formed by using the low-defect part YS. By increasing the width of the low-defect part YS (that is, increasing the size WL described above), the individual body LT having the single-sided two-electrode structure can be formed of the structure JT formed by using the low-defect part YS.

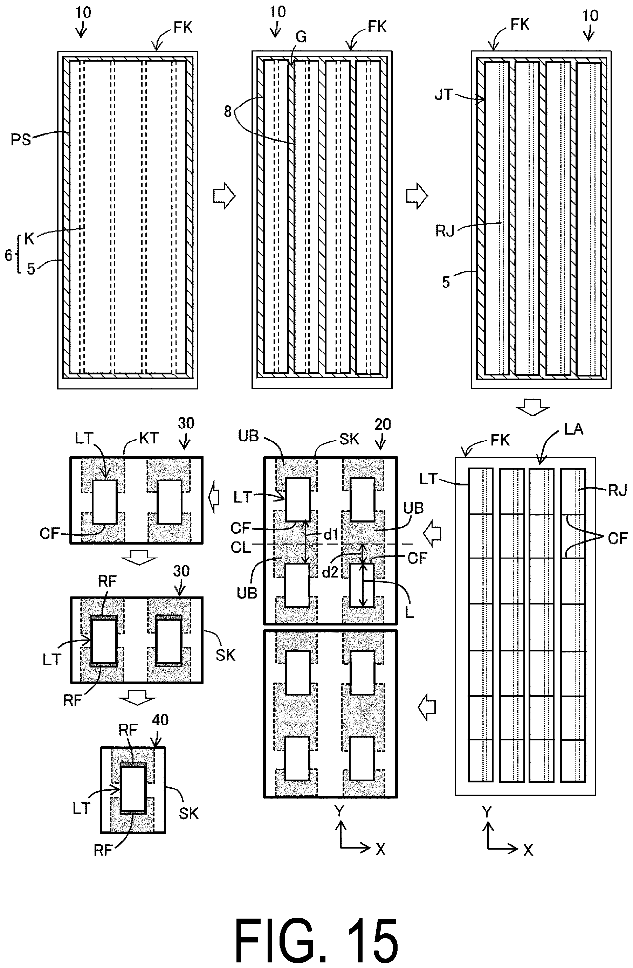

FIG. 15 is a plan view illustrating a manufacturing method for a semiconductor laser device according to an example. As illustrated in FIG. 15, the plurality of semiconductor parts 8 having the stripe shape may be formed by allowing crystals growing in mutually opposite directions (in the a-axis direction) on the mask part 5 to meet each other to form a planar semiconductor layer PS, and then removing a meeting part (high-defect region having a longitudinal shape) of the planar semiconductor layer PS. In one aspect of the present disclosure, the manufacturing method for the semiconductor laser device may include preparing the semiconductor substrate 10 including the first substrate FK and the plurality of semiconductor parts 8 having the stripe shape and obtained by crystal growth on the first substrate FK, and a specific method thereof is not particularly limited.

After the structure JT is divided by etching or the like, the end surface CF may be formed by cleaving. The semiconductor substrate 10 may be divided into a plurality of individual substrates 10D such that a cross section is generated at a trench part formed by etching or the like.

In the known technique of Patent Document 1, an element structure wafer and a support substrate need to be collectively cleaved after surfaces to be easily cleaved of the element structure wafer and the support substrate are precisely aligned. The support substrate is also required to include the surface to be easily cleaved. The support substrate also needs to be removed after light emitting end surfaces are formed and the wafer is individualized.
On the other hand, according to the above-described example, since the laser end surface (resonator end surface) is formed on the first substrate FK (growth substrate), a precise alignment step as in the known technique is not required, and a problem of cleavage failure hardly occurs. Since the transferring is performed to the second substrate SK after the laser end surface is formed, the second substrate SK does not need to include a surface to be easily cleaved, and precise alignment (for forming the laser end surface) is not required at the time of the transferring. Since the removing of the first substrate FK is performed in a wafer state before division by the transferring to the second substrate SK (sub-mount substrate), the manufacturing process is simple and suitable for mass production. Thus, according to the above-described example, a manufacturing yield of the semiconductor laser device is improved.

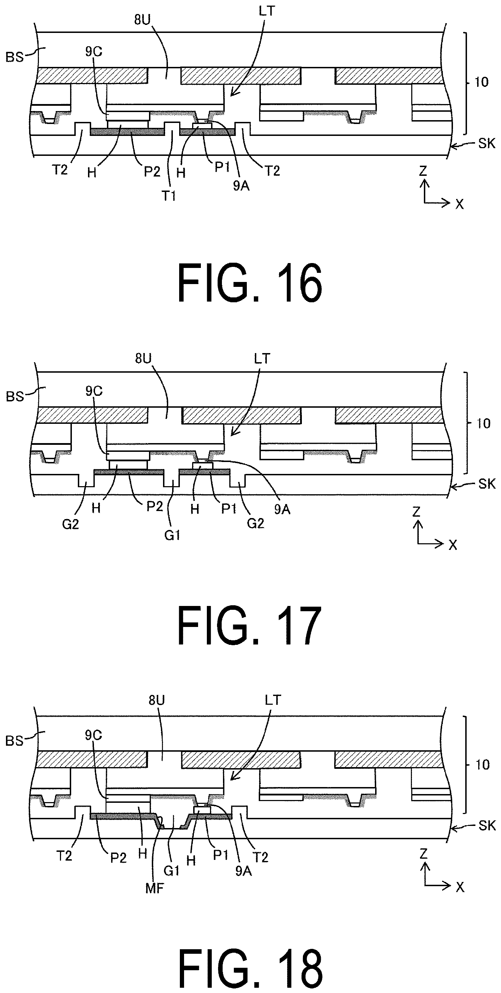

Each of FIG. 16 to FIG. 18 is a cross-sectional view illustrating a manufacturing method for a semiconductor laser device according to an example. In FIG. 16, the first individual body LT, which is one of the plurality of individual bodies to be transferred, includes the anode 9A, the second substrate SK includes a first protruding part T1 corresponding to the first individual body LT, and at least a part (all in a case of FIG. 16) of the first protruding part T1 is positioned on the inner side (a side closer to the center of the first individual body LT) than the anode 9A at the time of the transferring. The second substrate SK includes a second protruding part T2 corresponding to the first individual body LT, and the second protruding part T2 is positioned on the outer side (a side far from the center of the first individual LT) than the anode 9A at the time of the transferring. The anode 9A may be bonded to an electrode pad P1 of the second substrate SK with solder H interposed therebetween. In FIG. 16, the first protruding part T1 and/or the second protruding part T2 may function as a shielding wall for the solder H.

In FIG. 17, the first individual body LT, which is one of the plurality of individual bodies to be transferred, includes the anode 9A, the second substrate SK includes a first groove G1 corresponding to the first individual body LT, and at least a part (all in a case of FIG. 17) of the first groove G1 is positioned on the inner side (a side closer to the center of the first individual body LT) than the anode 9A at the time of the transferring. The second substrate SK includes a second groove G2 corresponding to the first individual body LT, and the second groove G2 is positioned on the outer side (a side far from the center of the first individual body LT) than the anode 9A at the time of the transferring. The anode 9A may be bonded to the electrode pad P1 of the second substrate SK with the solder H interposed therebetween. In FIG. 17, the first groove G1 and/or the second groove G2 may function as a trap groove for the solder H. The first groove side G1 and/or the second groove side G2 may include a side wall containing a metal. The first groove G1 and/or the second groove G2 may have a tapered shape (for example, a shape that becomes narrower toward the lower side). In plan view, the second groove G2 and the anode 9A may be parallel to the Y direction.

The second substrate SK in FIG. 18 includes the first groove G1 (at least a part thereof is positioned on the inner side than the anode 9A at the time of the transferring) and the second protruding part T2 (at least a part thereof is positioned on the outer side than the anode 9A at the time of the transferring). The first groove G1 may include a side wall MF containing a metal. The first groove G1 may have a tapered shape (a shape that becomes narrower toward the lower side).

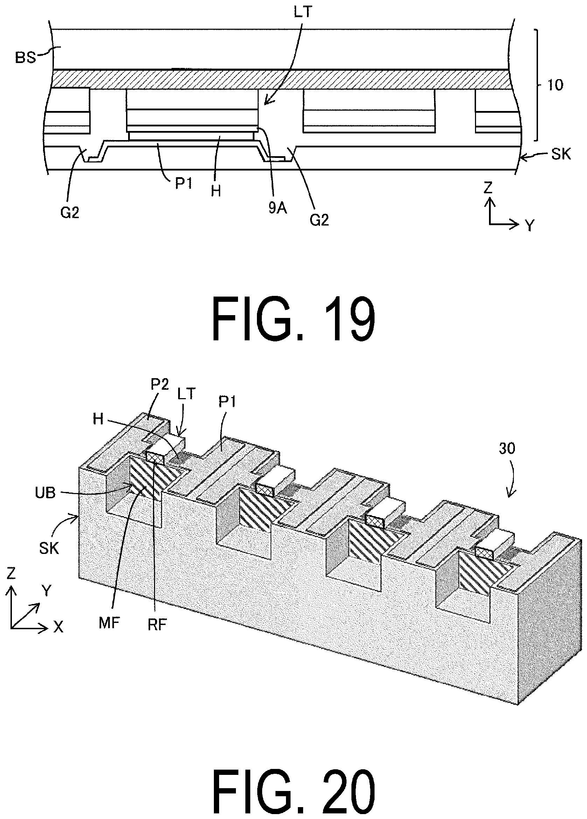

FIG. 19 is a cross-sectional view illustrating a manufacturing method for a semiconductor laser device according to an example. Although the second groove G2 extending in the Y direction (parallel to the resonator length direction) is formed on the outer side in the X direction in FIG. 17, the second groove G2 extending in the X direction (orthogonal to the resonator length direction) may be formed on the outer side in the Y direction as illustrated in FIG. 19.

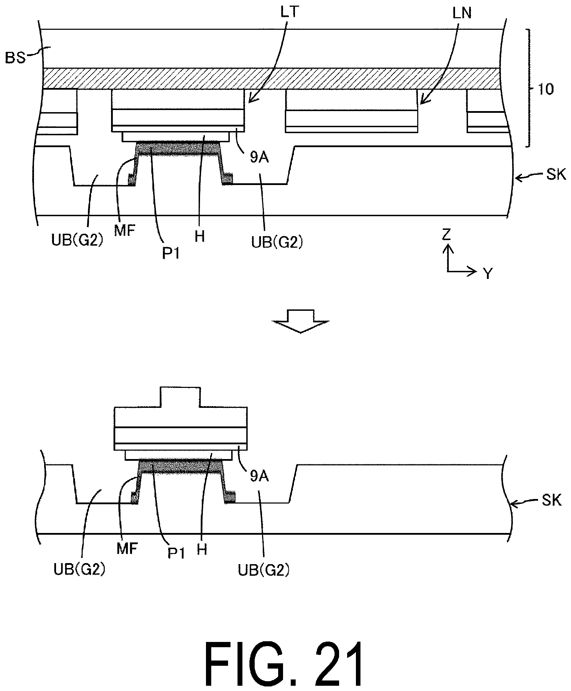

FIG. 20 is a perspective view illustrating a manufacturing method for a semiconductor laser device according to an example. FIG. 21 is a cross-sectional view illustrating the manufacturing method for the semiconductor laser device according to the example. As illustrated in FIG. 20 and FIG. 21, among a plurality of inner side walls formed by recessed parts UB (the second grooves G2), an inner side wall MF positioned under the first individual body LT may contain a metal. The anode 9A may be bonded to the electrode pad P1 of the second substrate SK with the solder H interposed therebetween. The inner side wall MF may be a tapered surface. According to the forms illustrated in FIG. 20 and FIG. 21, failures that the solder H flows out to an unintended region at the time of the transferring can be reduced.

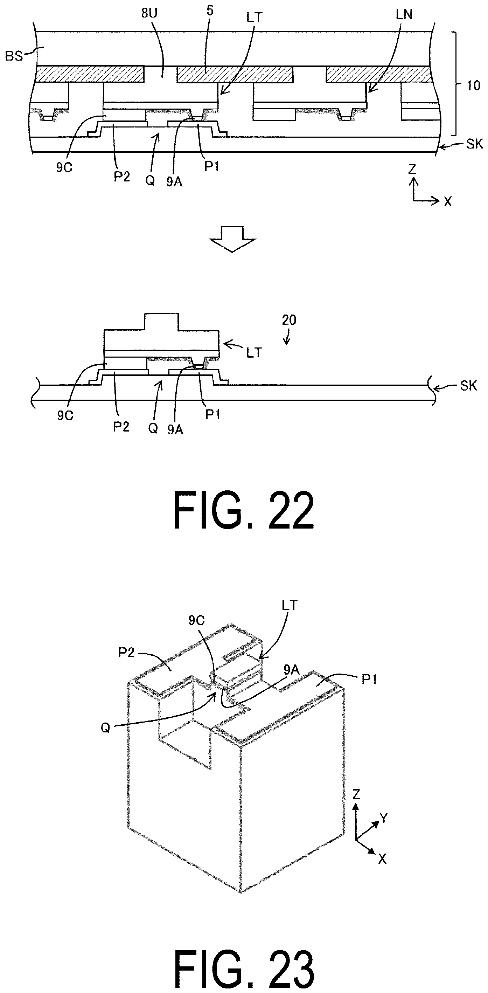

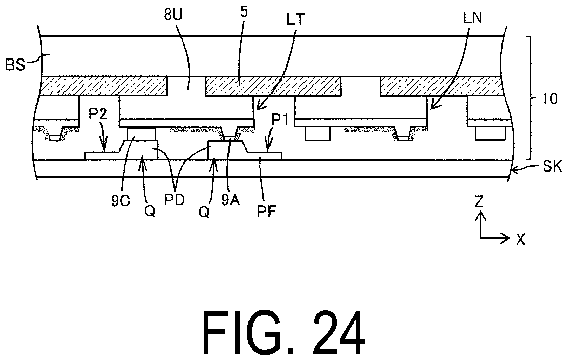

FIG. 22 is a cross-sectional view illustrating a manufacturing method for a semiconductor laser device according to an example. FIG. 23 is a perspective view illustrating the manufacturing method for the semiconductor laser device according to the example. In FIG. 22 and FIG. 23, the second substrate SK includes a hill part Q corresponding to the first individual body LT that is one of a plurality of individual bodies to be transferred, and the first individual body LT is disposed above the hill part Q at the time of the transferring. At the time of the transferring, a non-selected individual body LN in the individual body group does not need to be in contact with the second substrate SK. The second substrate SK may include the electrode pad P1, and at least a part of the electrode pad P1 may be positioned at the hill part Q. The first individual body LT may include the anode 9A, and the anode 9A and the electrode pad P1 may be in contact with each other. FIG. 24 is a cross-sectional view illustrating a manufacturing method for a semiconductor laser device according to an example. As illustrated in FIG. 24, the electrode pad P1 may include a thick film part PD positioned at the hill part Q and a thin film part PF having a thickness smaller than that of the thick film part PD. Since the second substrate SK includes the hill part Q, when the plurality of individual bodies are selectively transferred to the second substrate SK by a bonding method that does not use solder, such as Au (gold)-Au (gold) bonding, for example, the possibility that an individual body that is not a transfer target is transferred to the second substrate SK is reduced.

### Supplementary Note

Note that the present disclosure is not limited to the embodiments and the examples described above. Embodiments that are obtained by appropriately combining technical means disclosed in the different embodiments and examples are also included in the scope of the present disclosure. In other words, a person skilled in the art can easily make various variations or alterations based on the present disclosure, and embodiments obtained by these variations or alterations are also included in the scope of the present disclosure.

### Conclusion

According to a first aspect of the present disclosure, a manufacturing method for a semiconductor laser device includes preparing a semiconductor substrate including a first substrate and a plurality of semiconductor parts having a stripe shape and obtained by crystal growth on the first substrate, dividing each of a plurality of structures including a respective one of the plurality of semiconductor parts on the first substrate in a manner that an end surface parallel to a lateral direction is exposed at each of the plurality of structures and thus obtaining an individual body group, transferring a plurality of individual bodies included in the individual body group to a second substrate, and dividing the second substrate and thus obtaining each of a plurality of element substrates including a respective one or more of the plurality of individual bodies.

According to a second aspect of the present disclosure, in a method for manufacturing a semiconductor laser device, in the first aspect, the end surface functions as a resonator end surface, selective transfer is performed in a manner that the number of transferred individual bodies per unit area to the second substrate is less than the number of individual bodies per unit area in the individual body group, and the second substrate is divided while any of the individual bodies is not divided.

According to a third aspect of the present disclosure, in a manufacturing method for a semiconductor laser device, in the second aspect, when a direction corresponding to the lateral direction of the plurality of semiconductor parts is defined as a first direction and a direction corresponding to a longitudinal direction of the plurality of semiconductor parts is defined as a second direction at the second substrate, the plurality of individual bodies transferred to the second substrate are arranged in a matrix in the first direction and the second direction.

According to a fourth aspect of the present disclosure, in a method for manufacturing a semiconductor laser device, in the third aspect, an interval between the plurality of individual bodies in the second direction is equal to or larger than a size of each individual body in the second direction.

According to a fifth aspect of the present disclosure, in a method for manufacturing a semiconductor laser device, in the fourth aspect, the interval between the plurality of individual bodies in the second direction is a natural number multiple of the size.

According to a sixth aspect of the present disclosure, in a method for manufacturing a semiconductor laser device, in any one of the third to fifth aspects, the second substrate includes a plurality of recessed parts arranged in a matrix in the first direction and the second direction.

According to a seventh aspect of the present disclosure, in a method for manufacturing a semiconductor laser device, in the sixth aspect, an end surface parallel to the lateral direction of each of the plurality of individual bodies transferred to the second substrate is positioned above a respective one of the plurality of recessed parts.

According to an eighth aspect of the present disclosure, in a method for manufacturing a semiconductor laser device, in the sixth or seventh aspect, a cross section formed by dividing the second substrate includes at least one of the plurality of recessed parts.

According to a ninth aspect of the present disclosure, in a method for manufacturing a semiconductor laser device, in any one of the third to eighth aspects, respective two or more individual bodies of the plurality of individual bodies are arranged in a line in the first direction, at each of the plurality of element substrates.

According to a 10th aspect of the present disclosure, in a method for manufacturing a semiconductor laser device, in the ninth aspect, a dielectric film is formed on an end surface of each of the two or more individual bodies of the plurality of individual bodies arranged in the line at each element substrate.

According to an 11th aspect of the present disclosure, in a method for manufacturing a semiconductor laser device, in the fourth or fifth aspect, before the obtaining of the plurality of element substrates, a dielectric film is formed on an end surface of each of the plurality of individual bodies arranged in a matrix on the second substrate.

According to a 12th aspect of the present disclosure, in a method for manufacturing a semiconductor laser device, in any one of the first to 11th aspects, a resonator length of each of the plurality of individual bodies is 200 µm or less.

According to a 13th aspect of the present disclosure, in a method for manufacturing a semiconductor laser device, in any one of the first to 12th aspects, the plurality of bases are obtained by stealth dicing of the second substrate.

According to a 14th aspect of the present disclosure, in a method for manufacturing a semiconductor laser device, in any one of the first to 13th aspects, the end surface is formed by cleaving or etching.

According to a 15th aspect of the present disclosure, in a method for manufacturing a semiconductor laser device, in any one of the first to 14th aspects, each semiconductor part of the plurality of semiconductor parts includes a nitride semiconductor, and the end surface is parallel to an m-plane of the nitride semiconductor.

According to a 16th aspect of the present disclosure, in a method for manufacturing a semiconductor laser device, in any one of the first to 15th aspects, each of the first and second substrates includes a silicon substrate or a silicon carbide substrate.

According to a 17th aspect of the present disclosure, in a method for manufacturing a semiconductor laser device, in any one of the first to 16th aspects, the plurality of individual bodies are transferred to the second substrate, and at the same time, each individual body is electrically connected to an electrode pad of the second substrate.

According to an 18th aspect of the present disclosure, a method for manufacturing a semiconductor laser device, in any one of the first to 17th aspects, further includes dividing the semiconductor substrate including the plurality of individual bodies into a plurality of individual pieces.

According to a 19th aspect of the present disclosure, a method for manufacturing a semiconductor laser device, in any one of the first to 18th aspects, further includes scribing each of the plurality of structures.

According to a 20th aspect of the present disclosure, in a method for manufacturing a semiconductor laser device, in any one of the first to 19th aspects, each of the plurality of semiconductor parts includes a GaN-based semiconductor, and the first substrate includes a wafer made of a material having a thermal expansion coefficient less than a thermal expansion coefficient of the GaN-based semiconductor.

According to a 21st aspect of the present disclosure, in a method for manufacturing a semiconductor laser device, in any one of the first to 20th aspects, when the plurality of individual bodies are transferred to the second substrate, a connection crystal part between each of the plurality of individual bodies and the first substrate is broken.

According to a 22nd aspect of the present disclosure, in a method for manufacturing a semiconductor laser device, in any one of the first to 21st aspects, each of the plurality of structures includes a ridge including a nitride semiconductor, an electrode, and an insulating film.

According to a 23rd aspect of the present disclosure, in a method for manufacturing a semiconductor laser device, in the 22nd aspect, at least one selected from the group consisting of the electrode and the insulating film is not included in the end surface formed by dividing each of the plurality of structures.

According to a 24th aspect of the present disclosure, in a method for manufacturing a semiconductor laser device, in the 22nd or 23rd aspect, the end surface includes a cross section of the ridge, and the cross section functions as a resonator end surface.

According to a 25th aspect of the present disclosure, in a method for manufacturing a semiconductor laser device, in the first aspect, a first individual body that is one of the plurality of individual bodies to be transferred includes an anode, the second substrate includes a first protruding part corresponding to the first individual body, and the first protruding part is positioned on an inner side than the anode in the transferring.

According to a 26th aspect of the present disclosure, in a method for manufacturing a semiconductor laser device, in the first aspect, a first individual body that is one of the plurality of individual bodies to be transferred includes an anode, the second substrate includes a second protruding part corresponding to the first individual body, and the second protruding part is positioned on an outer side than the anode in the transferring.

According to a 27th aspect of the present disclosure, in a method for manufacturing a semiconductor laser device, in the first aspect, a first individual body that is one of the plurality of individual bodies to be transferred includes an anode, the second substrate includes a first groove corresponding to the first individual body, and the first groove is positioned on an inner side than the anode in the transferring.

According to a 28th aspect of the present disclosure, in a method for manufacturing a semiconductor laser device, in the first aspect, a first individual body that is one of the plurality of individual bodies to be transferred includes an anode, the second substrate includes a second groove corresponding to the first individual body, and the second groove is positioned on an outer side than the anode in the transferring.

According to a 29th aspect of the present disclosure, in a method for manufacturing a semiconductor laser device, in the 27th aspect, the first groove includes a side wall including a metal.

According to a 30th aspect of the present disclosure, in a method for manufacturing a semiconductor laser device, in the 28th aspect, the second groove includes a side wall including a metal.

According to a 31st aspect of the present disclosure, in a method for manufacturing a semiconductor laser device, in any one of the 25th to 30th aspects, the anode is bonded to the second substrate with solder interposed between the anode and the second substrate.

According to a 32nd aspect of the present disclosure, in a method for manufacturing a semiconductor laser device, in the first aspect, the second substrate includes a hill part corresponding to a first individual body that is one of the plurality of individual bodies to be transferred, and the first individual body is disposed above the hill part in the transferring.

According to a 33rd aspect of the present disclosure, in a method for manufacturing a semiconductor laser device, in the 32nd aspect, a non-selected individual body in the individual body group does not come into contact with the second substrate in the transferring.

According to a 34th aspect of the present disclosure, in a method for manufacturing a semiconductor laser device, in the 32nd or 33rd aspect, the second substrate includes an electrode pad, and at least a part of the electrode pad is positioned at the hill part.

According to a 35th aspect of the present disclosure, in a method for manufacturing a semiconductor laser device, in the 34th aspect, the electrode pad includes a thick film part positioned at the hill part and a thin film part having a film thickness less than a film thickness of the thick film part.

According to a 36th aspect of the present disclosure, in a method for manufacturing a semiconductor laser device, in the 34th or 35th aspect, the first individual body includes an anode, and the anode comes into contact with the electrode pad.

According to the 25th aspect of the present disclosure, an apparatus for manufacturing a semiconductor laser device performs the manufacturing method according to any one of the first to 24th aspects.

### REFERENCE SIGNS

1 Main substrate
4 Underlying part
5 Mask part
6 Mask pattern
8 Semiconductor part
10 Semiconductor substrate
20 Element substrate (semiconductor laser device)
30 Element substrate (semiconductor laser device)
40 Laser element (semiconductor laser device)
JT Structure
CF End surface
LT Individual body (laser body)
BS Base substrate
FK First substrate
SK Second substrate
K Opening
G Gap

## Claims

1. A manufacturing method for a semiconductor laser device comprising:
preparing a semiconductor substrate comprising a first substrate and a plurality of semiconductor parts having a stripe shape, the plurality of semiconductor parts being obtained by crystal growth on the first substrate;
dividing each of a plurality of structures comprising a respective one of the plurality of semiconductor parts on the first substrate in a manner that an end surface parallel to a lateral direction is exposed at each of the plurality of structures, and thus obtaining an individual body group;
transferring a plurality of individual bodies comprised in the individual body group to a second substrate; and
dividing the second substrate, and thus obtaining each of a plurality of element substrates comprising a respective one or more of the plurality of individual bodies.

2. The manufacturing method for the semiconductor laser device according to claim 1, wherein
the end surface comprises a resonator end surface,
selective transfer is performed in a manner that the number of transferred individual bodies per unit area to the second substrate is less than the number of individual bodies per unit area in the individual body group, and
the second substrate is divided while any of the plurality of individual bodies is not divided.

3. The manufacturing method for the semiconductor laser device according to claim 2, wherein
when a direction corresponding to the lateral direction of the plurality of semiconductor parts is defined as a first direction, and a direction corresponding to a longitudinal direction of the plurality of semiconductor parts is defined as a second direction at the second substrate, the plurality of individual bodies transferred to the second substrate are arranged in a matrix in the first direction and the second direction.

4. The manufacturing method for the semiconductor laser device according to claim 3, wherein
an interval between the plurality of individual bodies in the second direction is equal to or larger than a size of each individual body in the second direction.

5. The manufacturing method for the semiconductor laser device according to claim 4, wherein
the interval between the plurality of individual bodies in the second direction is a natural number multiple of the size.

6. The manufacturing method for the semiconductor laser device according to claim 3, wherein
the second substrate comprises a plurality of recessed parts arranged in the matrix in the first direction and the second direction.

7. The manufacturing method for the semiconductor laser device according to claim 6, wherein
an end surface parallel to the lateral direction of each of the plurality of individual bodies transferred to the second substrate is positioned above a respective one of the plurality of recessed parts.

8. The manufacturing method for the semiconductor laser device according to claim 6, wherein
a cross section formed by dividing the second substrate comprises at least one of the plurality of recessed parts.

9. The manufacturing method for the semiconductor laser device according to claim 3, wherein
at each of the plurality of element substrates, respective two or more individual bodies of the plurality of individual bodies are arranged in a line in the first direction.

10. The manufacturing method for the semiconductor laser device according to claim 9, wherein
a dielectric film is formed on an end surface of each of the two or more individual bodies of the plurality of individual bodies arranged in the line at each element substrate.

11. The manufacturing method for the semiconductor laser device according to claim 4, wherein
before the obtaining of the plurality of element substrates, a dielectric film is formed on an end surface of each of the plurality of individual bodies arranged in the matrix on the second substrate.

12. The manufacturing method for the semiconductor laser device according to claim 1, wherein
a resonator length of each of the plurality of individual bodies is 200 µm or less.

13. The manufacturing method for the semiconductor laser device according to claim 1, wherein
the plurality of element substrates are obtained by stealth dicing of the second substrate.

14. The manufacturing method for the semiconductor laser device according to claim 1, wherein
the end surface is formed by cleaving or etching.

15. The manufacturing method for the semiconductor laser device according to claim 1, wherein
each of the plurality of semiconductor parts comprises a nitride semiconductor, and the end surface is parallel to an m-plane of the nitride semiconductor.

16. The manufacturing method for the semiconductor laser device according to claim 1, wherein
each of the first substrate and the second substrate comprises a silicon substrate or a silicon carbide substrate.

17. The manufacturing method for the semiconductor laser device according to claim **1,** wherein
teach of the plurality of individual bodies is electrically connected to an electrode pad of the second substrate at the same time as the plurality of individual bodies are transferred to the second substrate.

18. The manufacturing method for the semiconductor laser device according to claim **1,** the manufacturing method further comprising:
dividing the semiconductor substrate comprising the plurality of individual bodies into a plurality of individual pieces.

19. The manufacturing method for the semiconductor laser device according to claim **1,** the manufacturing method further comprising:
scribing each of the plurality of structures.

20. The manufacturing method for the semiconductor laser device according to claim **1,** wherein
each of the plurality of semiconductor parts comprises a GaN-based semiconductor, and
the first substrate comprises a wafer made of a material having a thermal expansion coefficient less than a thermal expansion coefficient of the GaN-based semiconductor.

21. The manufacturing method for the semiconductor laser device according to claim **1,** wherein
a connection crystal part between each of the plurality of individual bodies and the first substrate is broken when the plurality of individual bodies are transferred to the second substrate.

22. The manufacturing method for the semiconductor laser device according to claim **1,** wherein
each of the plurality of structures comprises a ridge comprising a nitride semiconductor, an electrode, and an insulating film.

23. The manufacturing method for the semiconductor laser device according to claim 22, wherein
at least one selected from the group consisting of the electrode and the insulating film is not comprised in the end surface formed by dividing each of the plurality of structures.

24. The manufacturing method for the semiconductor laser device according to claim 22, wherein
the end surface comprises a cross section of the ridge, and the cross section functions as a resonator end surface.

25. The manufacturing method for the semiconductor laser device according to claim 1, wherein
a first individual body that is one of the plurality of individual bodies to be transferred comprises an anode,
the second substrate comprises a first protruding part corresponding to the first individual body, and
the first protruding part is positioned on an inner side than the anode in the transferring.

26. The manufacturing method for the semiconductor laser device according to claim 1, wherein
a first individual body that is one of the plurality of individual bodies to be transferred comprises an anode,
the second substrate comprises a second protruding part corresponding to the first individual body, and
the second protruding part is positioned on an outer side than the anode in the transferring.

27. The manufacturing method for the semiconductor laser device according to claim 1, wherein
a first individual body that is one of the plurality of individual bodies to be transferred comprises an anode,
the second substrate comprises a first groove corresponding to the first individual body, and
the first groove is positioned on an inner side than the anode in the transferring.

28. The manufacturing method for the semiconductor laser device according to claim 1, wherein
a first individual body that is one of the plurality of individual bodies to be transferred comprises an anode,
the second substrate comprises a second groove corresponding to the first individual body, and
the second groove is positioned on an outer side than the anode in the transferring.

29. The manufacturing method for the semiconductor laser device according to claim 27, wherein
the first groove comprises a side wall comprising a metal.

30. The manufacturing method for the semiconductor laser device according to claim 28, wherein
the second groove comprises a side wall comprising a metal.

31. The manufacturing method for the semiconductor laser device according to any one of claims 25 to 30, wherein
the anode is bonded to the second substrate with solder interposed between the anode and the second substrate.

32. The manufacturing method for the semiconductor laser device according to claim 1, wherein
the second substrate comprises a hill part corresponding to a first individual body that is one of the plurality of individual bodies to be transferred, and the first individual body is disposed above the hill part in the transferring.

33. The manufacturing method for the semiconductor laser device according to claim 32, wherein
a non-selected individual body in the individual body group does not come into contact with the second substrate in the transferring.

34. The manufacturing method for the semiconductor laser device according to claim 32 or 33, wherein
the second substrate comprises an electrode pad, and
at least a part of the electrode pad is positioned at the hill part.

35. The manufacturing method for the semiconductor laser device according to claim 34, wherein
the electrode pad comprises a thick film part positioned at the hill part and a thin film part having a film thickness less than a film thickness of the thick film part.

36. The manufacturing method for the semiconductor laser device according to claim 34 or 35, wherein
the first individual body comprises an anode, and
the anode comes into contact with the electrode pad.

37. A manufacturing apparatus for a semiconductor laser device, the manufacturing apparatus performing each process of the manufacturing method for the semiconductor laser device according to claim 1.
